# EUROPEAN PATENT APPLICATION

(11) **EP 4 845 346 A1**
(43) Date of publication of application: **25.11.2026**
(21) Application number: 25213456.4
(22) Date of filing: 04.11.2025
(51) Int. Cl.: H10F 19/75, H10F 77/20

(54) **BACK CONTACT SOLAR CELL, TANDEM SOLAR CELL, AND PHOTOVOLTAIC MODULE**

(30) Priority: 21.05.2025 CN 202510661235
(71) Applicant: Shangrao Jinko Solar No.3 Intelligent Manufacturing Co., Ltd., Shangrao City, Jiangxi 333100 (CN); Jinko Solar (Haining) Co., Ltd., Haining City, Zhejiang (CN)
(72) Inventor: QIU, Lifeng, Shangrao (CN); XIA, Zhipeng, Shangrao (CN); YANG, Jie, Shangrao (CN); HUANG, Jide, Shangrao (CN); LIU, Changming, Shangrao (CN); ZHANG, Xinyu, Shangrao (CN)
(74) Representative: Balder IP Law, S.L.

(57) **Abstract**

The disclosed relates to the technical field of photovoltaics and provides a back contact solar cell, a tandem solar cell and a photovoltaic module. The back contact solar cell includes a substrate, a first doped conductive layer disposed on first regions, a second doped conductive layer disposed on second regions, doped conductive contacts, and grid lines in electrical contact with the first doped conductive layer. The first doped conductive layer is doped with a dopant element of a conductivity type opposite to that of a dopant element in the second doped conductive layer. Each doped conductive contact of the doped conductive contacts is at least partially disposed on a respective separating region of separating regions, and is configured for electrically connecting the first and second doped conductive layers. The doped conductive contacts are doped with a dopant element of a conductivity type same as that of the dopant element in the second doped conductive layer. In a first direction, one respective grid line of the grid lines spaces from a doped conductive contact of the doped conductive contacts adjacent to the respective grid line by a first spacing greater than or equal to 20µm. The disclosed can at least improve a hot spot phenomenon of the back contact solar cell and enhance a performance of the back contact solar cell.

## Description

### TECHNICAL FIELD

The present disclosure relates to the technical field of photovoltaics, and in particular to a back contact solar cell, a tandem solar cell, and a photovoltaic module.

### BACKGROUND

As fossil energy resources are gradually being depleted, solar cells have been widely used as a new energy alternative. A solar cell is an apparatus for converting solar energy into electrical energy. The solar cell generates carriers based on a photovoltaic principle, and the carriers are led out by electrodes, thereby enabling effective utilization of the electrical energy.

A back contact solar cell is a crystalline silicon solar cell with both emitter electrodes and base electrodes being disposed on a back of the back contact solar cell. With no metal grid lines blocking a front side of the back contact solar cell, the back contact solar cell absorbs light more efficiently, significantly increasing short-circuit current. In addition, a surface of the back contact solar cell is passivated by doped amorphous silicon or microcrystalline silicon, thereby increasing open-circuit voltage. These factors effectively improve a conversion efficiency of the back contact solar cell, causing them promising for future development.

Currently, the back contact solar cell suffers from a hot spot phenomenon, and it is necessary to propose a back contact solar cell to improve the hot spot phenomenon of the back contact solar cell.

### SUMMARY

Embodiments of the present disclosure provide a back contact solar cell, a tandem solar cell, and a photovoltaic module, which are at least beneficial in improving the hot spot phenomenon of the back contact solar cell and enhancing the performance of the back contact solar cell.

Some embodiments of the present disclosure provide a back contact solar cell, which includes: a substrate having a first side and an opposing second side, wherein the second side includes alternating first regions and second regions, and further includes separating regions, and each separating region of the separating regions is disposed between a respective first region of the first regions and a respective second region of the second regions adjacent to the respective first region; a first doped conductive layer and a second doped conductive layer, wherein the first doped conductive layer is disposed on the first regions, the second doped conductive layer is disposed on the second regions, and the first doped conductive layer is doped with a dopant element of a conductivity type opposite to that of a dopant element in the second doped conductive layer; doped conductive contacts, wherein each doped conductive contact of the doped conductive contacts is at least partially disposed on a respective separating region of the separating regions and is configured for electrically connecting the first doped conductive layer to the second doped conductive layer, and the doped conductive contacts are doped with a dopant element of a conductivity type same as that of the dopant element in the second doped conductive layer; and grid lines, wherein each grid line of the grid lines is disposed on a respective first region of the first regions and is in electrical contact with the first doped conductive layer. In a first direction perpendicular to an extension direction of the grid lines, one respective grid line of the grid lines spaces from a doped conductive contact of the doped conductive contacts adjacent to the respective grid line by a first spacing greater than or equal to 20µm.

In some embodiments, each respective doped conductive contact of at least some of the doped conductive contacts includes: a connecting part disposed on a corresponding separating region of the separating regions and configured for electrically connecting to the second doped conductive layer; and a contact part disposed on a corresponding first region of the first regions and configured for electrically connecting to the first doped conductive layer.

In some embodiments, along the first direction, a ratio of a distance between the contact part and a corresponding grid line of the grid lines adjacent to the contact part along the first direction to a length of the contact part along the first direction ranges from 1 to 10.

In some embodiments, the length of the contact part ranges from 20µm to 100µm, and the distance between the contact part and the corresponding grid line along the first direction ranges from 20µm to 150µm.

In some embodiments, the first doped conductive layer includes first doped conductive parts each extending along the first direction and second doped conductive parts each extending along a second direction, and the second doped conductive layer includes third doped conductive parts each extending along the first direction and fourth doped conductive parts each extending along the second direction. In the second direction, one respective between the first doped conductive part of the first doped conductive parts spaces from a second doped conductive part of the second doped conductive parts adjacent to the respective first doped conductive part by a second spacing. A ratio of a width of one respective doped conductive contact of the doped conductive contacts along the second direction to the second spacing ranges from 0.01 to 0.05.

In some embodiments, the width ranges from 40µm to 350µm, and the second spacing ranges from 5mm to 15mm.

In some embodiments, the doped conductive contacts are disposed at equal intervals along the first direction and disposed at equal intervals along a second direction parallel to the extension direction of the grid lines.

In some embodiments, along the first direction, a respective distance between every two adjacent doped conductive contacts of the doped conductive contacts ranges from 4.2mm to 17mm, and along the second direction, a respective distance between every two adjacent doped conductive contacts of the doped conductive contacts ranges from 5mm to 20mm.

In some embodiments, the doped conductive contacts and the second doped conductive layer are formed integrally.

Some embodiments of the present disclosure provide a tandem solar cell, including: a bottom cell, wherein the bottom cell is the back contact solar cell described in any of the above embodiments; and a top cell formed on the bottom cell.

Some embodiments of the present disclosure provides a photovoltaic module, including: at least one cell string formed by connecting a plurality of back contact solar cells or, formed by connecting a plurality of tandem solar cells, wherein each back contact solar cell of the plurality of back contact solar cells and each tandem solar cell of the plurality of tandem solar cells are described in the above embodiments; at least one encapsulating film configured for covering at least one surface of the at least one cell string; and at least one cover plate configured for covering at least one surface of the at least one encapsulating film away from the at least one cell string.

The technical solutions provided by the embodiments of the present disclosure have at least the following advantages:

Doped conductive contacts configured for electrically connecting the first doped conductive layer to the second doped conductive layer is provided in the back contact solar cell. When the back contact solar cell is partially blocked or the back contact solar cell has an abnormality causing local heating, the doped conductive contacts can shunt current and cause the current not to be concentrated entirely on a blocked region or an abnormal heating region of the back contact solar cell, thereby reducing a current density in the blocked region or the abnormal heating region, helping to reduce a heating power of the blocked region or the abnormal heating region, thereby improving a hot spot effect of the back contact solar cell.

The doped conductive contacts are doped with a dopant element of a conductivity type same as that of the dopant element in the second doped conductive layer, and t the first doped conductive layer is doped with a dopant element of a conductivity type opposite to that of the dopant element in the second doped conductive layer. Therefore, the conductivity type of the dopant element in the first doped conductive layer is opposite to that of the dopant element in the doped conductive contacts. The grid lines are configured for electrically connecting to the first doped conductive layer. One respective grid line of the grid lines spaces from a doped conductive contact of the doped conductive contacts adjacent to the respective grid line by a first spacing greater than or equal to 20µm, which can avoid a situation where a reverse saturation current of the back contact solar cell is large due to the spacing between the doped conductive contact and the respective grid line being too small, thereby affecting the performance of the back contact solar cell. In other words, the spacing between the doped conductive contact and the respective grid line is greater than or equal to 20µm, which is beneficial to reducing the reverse saturation current of the back contact solar cell, thereby helping to improve the performance of the back contact solar cell.

### BRIEF DESCRIPTION OF THE DRAWINGS

One or more embodiments are illustrated by way of Figures in the drawings. These illustrations do not constitute a limitation of the embodiments, unless explicitly stated otherwise, and the drawings are not drawn to scale. For the purpose of more clearly describing the technical solution of the embodiments of the present disclosure or conventional techniques, a brief introduction of the drawings used in the embodiments is provided below. It is apparent that the drawings described below are merely some embodiments of the present disclosure, and those skilled in the art can obtain other drawings based on these drawings without exercising inventive skill.
FIG. 1 is a schematic structural diagram of a back contact solar cell provided in some embodiments of the present disclosure;
FIG. 2 is a partial top view of a back contact solar cell provided in some embodiments of the present disclosure;
FIG. 3 is a partial enlarged schematic diagram of A in FIG. 2;
FIG. 4 is another partial top view of a back contact solar cell provided in some embodiments of the present disclosure;
FIG. 5 is a partial enlarged schematic diagram of B in FIG. 2;
FIG. 6 is a schematic structural diagram of a tandem solar cell provided in some embodiments of the present disclosure;
FIG. 7 is a schematic diagram of a partial three-dimensional structure of a cell string in a photovoltaic module provided in some embodiments of the present disclosure;
FIG. 8 is a schematic diagram of a cross-sectional structure of a photovoltaic module provided in some embodiments of the present disclosure.

### DETAILED DESCRIPTION OF THE EMBODIMENTS

As can be seen from the background, currently, the back contact solar cell suffers from a hot spot phenomenon when they are partially blocked or experience anomalies. The hot spot phenomenon occurs when certain regions of the back contact solar cell or component are significantly hotter than other regions due to local overheating. This phenomenon is typically caused by uneven current distribution or excessively high local resistance, and may severely impact a performance and lifespan of the back contact solar cell. Therefore, it is necessary to improve the hot spot phenomenon of the back contact solar cell.

Embodiments of the present disclosure provide a back contact solar cell, a tandem solar cell, and a photovoltaic module. Doped conductive contacts configured for electrically connecting the first doped conductive layer and the second doped conductive layer is provided in the back contact solar cell. When the back contact solar cell is partially blocked or the back contact solar cell has an abnormality causing local heating, the doped conductive contacts can shunt current and cause the current not to be concentrated entirely on a blocked region or an abnormal heating region of the back contact solar cell, thereby reducing a current density in the blocked region or the abnormal heating region, helping to reduce a heating power of the blocked region or the abnormal heating region, thereby improving a hot spot effect of the back contact solar cell. In addition, one respective grid line of the grid lines spaces from a doped conductive contact of the doped conductive contacts adjacent to the respective grid line by a first spacing greater than or equal to 20µm, which is beneficial to reducing the reverse saturation current of the back contact solar cell, thereby helping to improve the performance of the back contact solar cell.

In the description of embodiments of the present disclosure, technical terms such as "first", "second", etc. are merely used to distinguish different objects, and cannot be understood as indicating or implying relative importance, or implicitly indicating the number, a particular order or primary and secondary relations of indicated technical features. In the description of embodiments of the present disclosure, "a plurality of" means two or more, unless otherwise explicitly and specifically defined.

The "embodiments" mentioned herein means that particular features, structures or characteristics described with reference to the embodiments may be included in one or more embodiments of the present disclosure. Phrases appearing at various positions of the specification neither always refer to the same embodiments, nor separate or alternative embodiments that are mutually exclusive with other embodiments. It is explicitly and implicitly understood by those skilled in the art that the embodiments described herein may be combined with other embodiments.

In the description of embodiments of the present disclosure, the term "and/or" is merely an association relationship describing associated objects, indicating that three relationships can exist. For example, A and/or B can indicate that there are three cases of A alone, A and B together, and B alone. In addition, the character "/" herein generally means that associated objects before and after "/" are in an "or" relationship.

In the description of embodiments of the present disclosure, the term "a plurality of" means two or more. Similarly, "a plurality of groups" means two or more groups, and "a plurality of pieces" means two or more pieces.

In the description of embodiments of the present disclosure, it should be understood that the technical terms "center", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential" etc. indicate the orientations or positional relationships on the basis of the drawings. These terms are only for the convenience of describing the present disclosure and simplifying the description, rather than indicating or implying that the related devices or element must have the specific orientations, or be constructed or operated in the specific orientations, and therefore cannot be understood as limitations of the present disclosure.

In the description of embodiments of the present disclosure, unless otherwise clearly specified and defined, the technical terms "installed", "connected", "coupled", "fixed" and the like should be understood broadly. For example, an element, when being referred to as being "installed", "connected", "coupled", or "fixed" to another element, unless otherwise specifically defined, may be fixedly connected, detachably connected, or integrated to the other element, may be mechanical connected or electrically connected to the other element, and may be directly connected to the other element or connected to the other element via an intermediate medium, or may be the internal connection of two elements or the interaction relationship between them. For those skilled in the art, the specific meanings of the above terms in the present disclosure may be understood according to specific circumstances.

In the drawings corresponding to embodiments of the present disclosure, the thicknesses and areas of layers are exaggerated for better understanding and ease of description. When a component (e.g., a layer, a film, a region, or a substrate) is described as on another component or on a surface thereof, it may be "directly" on the surface of the other component or a third component may be present between the two components. Conversely, when a component is described as on a surface of another component or another component is formed or provided on a surface of a component, there is no third component between the two components. Furthermore, when a component is described as formed "substantially" on another component, the component is neither formed on the entire surface (or entire front surface) of the other component, nor formed on a partial edge of the entire surface.

In the description of embodiments of the present disclosure, when a component "includes" another component, other components are not excluded, unless otherwise stated, and the other components may be further included. Furthermore, when a layer, a film, a region, a plate, or the like, is referred to as "on/disposed on" another component, it may be "directly on" the other component (i.e., on a surface of the other component, there is no another component between the two components), or another component is present between the two components. Furthermore, when a layer, a film, a region, a plate, or the like, is "directly disposed on" another component, or when a layer, a film, a region, a plate, or the like, is disposed on a surface of another component, there is no another component between the two components.

Embodiments of the present disclosure will be described in detail below with reference to the accompanying drawings. However, it may be appreciated by those of ordinary skill in the art that in the embodiments of the present disclosure, numerous technical details are set forth to enable better understanding the embodiments of the present disclosure. However, it is possible to implement the technical solution claimed by the embodiments of the present disclosure without these technical details and variations and modifications based on the following embodiments.

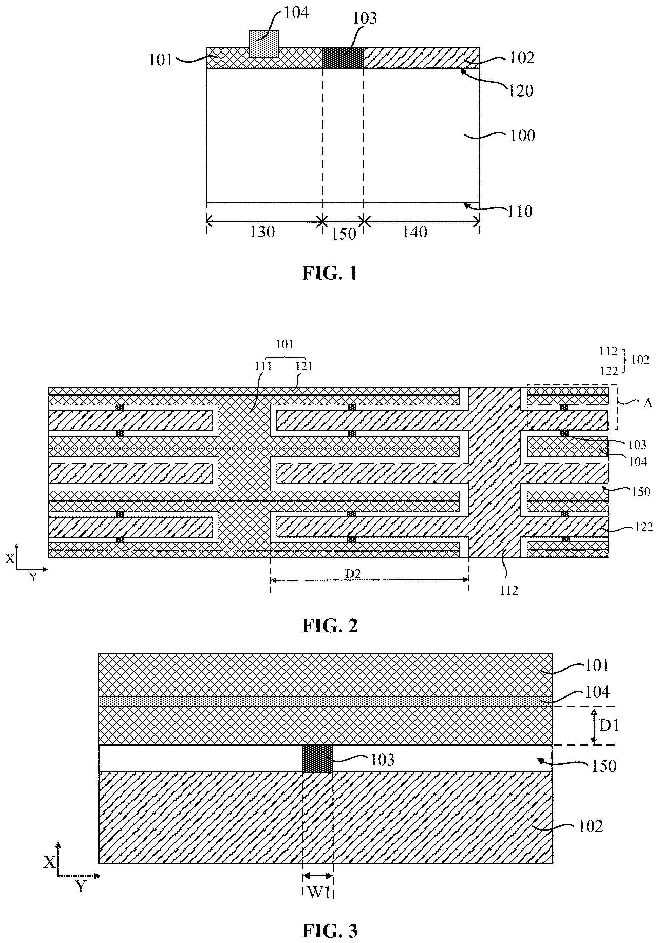

FIG. 1 is a schematic structural diagram of a back contact solar cell provided in some embodiments of the present disclosure. FIG. 2 is a partial top view of a back contact solar cell provided in some embodiments of the present disclosure. And FIG. 3 is a partial enlarged schematic diagram of A in FIG. 2.

Referring to FIGS. 1 to 3, the back contact solar cell includes a substrate 100, a first doped conductive layer 101, a second doped conductive layer 102, doped conductive contacts 103 and first grid lines 104. The substrate 100 includes a first side 110 and an opposing second side 120. The second side 120 includes alternating first regions 130 and second regions 140, and further includes separating regions 150, and each separating region 150 of the separating regions 150 is disposed between a respective first region 130 of the first regions 130 and a respective second region 140 of the second regions 140 adjacent to the respective first region 130. The first doped conductive layer 101 is disposed on the first regions 130, and the second doped conductive layer 102 is disposed on the second regions 140. The first doped conductive layer 101 is doped with a dopant element of a conductivity type of the dopant element is opposite to that of a dopant element in the second doped conductive layer 102. Each doped conductive contact 103 of the doped conductive contacts 103 is at least partially disposed on a respective separating region 150 of the separating regions 150, and is configured for electrically connecting the first doped conductive layer 101 and the second doped conductive layer 102. The doped conductive contacts 103 are doped with a dopant element of a conductivity type same as that of the dopant element in the second doped conductive layer 102. Each first grid line 104 of the first grid lines 104 is disposed on a respective first region 130 of the first regions 130 and is in electrical contact with the first doped conductive layer 101. In a first direction X, one respective first grid line 104 of the first grid lines 104 spaces from a doped conductive contact 104 of the doped conductive contacts 103 adjacent to the respective first grid line 104 by a first spacing D1 greater than or equal to 20µm.

Herein, the first direction X refers to a direction perpendicular to an extension direction of the first grid lines 104, and a second direction Y refers to a direction parallel to the extension direction of the first grid lines 104.

In some embodiments, the back contact solar cell may be an Interdigitated Back Contact (IBC) cell, a Hybrid Passivated Back Contact (HPBC) cell, a TOPCon Back Contact (TBC) cell integrating a Tunnel Oxide Passivated Contact (TOPCon) technology and an IBC technology, a Heterojunction Back Contact (HBC) cell integrating a Heterojunction Technology (HIT/HJT) and the IBC technology, or the like. The back contact solar cell may also be other types of back contact solar cells.

The back contact solar cell may or may not have busbars.

The substrate 100 is configured for receiving incident light and generate photo-induced carriers. In some embodiments, the substrate 100 may be a semiconductor substrate 100, such as silicon, germanium, silicon germanium, or silicon on an insulator.

In some embodiments, the substrate 100 may be made of an elemental semiconductor material. The elemental semiconductor material is composed of a single element, such as silicon or germanium. The elemental semiconductor material may be in a single crystalline state, a polycrystalline state, an amorphous state, or a microcrystalline state (including both single crystalline and amorphous states). For example, silicon may be at least one of single crystalline silicon, polycrystalline silicon, amorphous silicon, or microcrystalline silicon. When the substrate is made of silicon, the substrate 100 may include at least one of single crystalline silicon, polycrystalline silicon, amorphous silicon, or microcrystalline silicon.

The substrate 100 may be an N-type semiconductor substrate or a P-type semiconductor substrate. The N-type semiconductor substrate is doped with an N-type dopant element, which may be any Group-V element such as phosphorus (P) element, bismuth (Bi) element, antimony (Sb) element, or arsenic (As) element. The P-type semiconductor substrate is doped with a P-type dopant element, which may be any Group-III element such as boron (B) element, aluminum (Al) element, gallium (Ga) element, or indium (In) element.

The back contact solar cell is a single-sided cell. The first side 110 of the substrate 100 is configured as a light-receiving side for receiving incident light, and the second side 120 of the substrate 100 is configured as a backlight side.

The first regions 130 are regions where an orthographic projection of the first doped conductive layer 101 on the second side 120 is located. The second regions 140 are regions where an orthographic projection of the second doped conductive layer 102 on the second side 120 is located. Each separating region 150 of the separating regions 150 is disposed between a respective first region 130 of the first regions 130 and a respective second region 140 of the second regions 140 adjacent to the respective first region 130.

The first doped conductive layer 101 is doped with one of a P-type dopant element and an N-type dopant element, and the second doped conductive layer 102 is doped with the other of the P-type dopant element and the N-type dopant element.

The first doped conductive layer 101 may be made of at least one of amorphous silicon, silicon carbide, microcrystalline silicon or polycrystalline silicon.

The second doped conductive layer 102 may be made of at least one of amorphous silicon, silicon carbide, microcrystalline silicon or polycrystalline silicon.

Each first grid line 104 of the first grid lines 104 is in electrical contact with the first doped conductive layer 101. The first grid lines 104 are configured for transmitting current collected by the first doped conductive layer 101.

In some embodiments, the back contact solar cell may include second grid lines (not shown). Each second grid line of the second grid lines is disposed on a respective second region 140 of the second regions 140 and electrically connected to the second doped conductive layer 102.

The second grid lines are configured for transmitting current collected by the second doped conductive layer 102.

In some embodiments, the back contact solar cell may further include passivation layers (not shown), which are disposed on a surface of the first doped conductive layer 101 away from the second side 120, disposed on a surface of the second doped conductive layer 102 away from the second side 120, and disposed on surfaces of the doped conductive contacts 103 away from the second side 120.

The passivation layers may include single-layer film structures or stacked-layer film structures. The passivation layer may be made of any one or more of silicon oxide, silicon nitride, silicon oxynitride, silicon carbonitride oxide, titanium oxide, hafnium oxide or aluminum oxide.

A dopant element in the doped conductive contacts 103 has a same conductivity type as that of a dopant element in the second doped conductive layer 102. For example, when the dopant element in the second doped conductive layer 102 is a P-type dopant element, the dopant element in the doped conductive contacts 103 is also a P-type dopant element; when the dopant element in the second doped conductive layer 102 is an N-type dopant element, the dopant element in the doped conductive contacts 103 is also an N-type dopant element.

Each doped conductive contact 103 of the doped conductive contacts 103 is configured for connecting the first doped conductive layer 101 to the second doped conductive layer 102. In response to the back contact solar cell being locally blocked or the back contact solar cell being abnormal resulting in local heating, the doped conductive contacts 103 may shunt current and cause the current not to be concentrated entirely on a blocked region or an abnormal heating region of the back contact solar cell, thereby reducing a current density in the blocked region or the abnormal heating region, helping to reduce a heating power of the blocked region or the abnormal heating region, thereby improving a hot spot effect of the back contact solar cell.

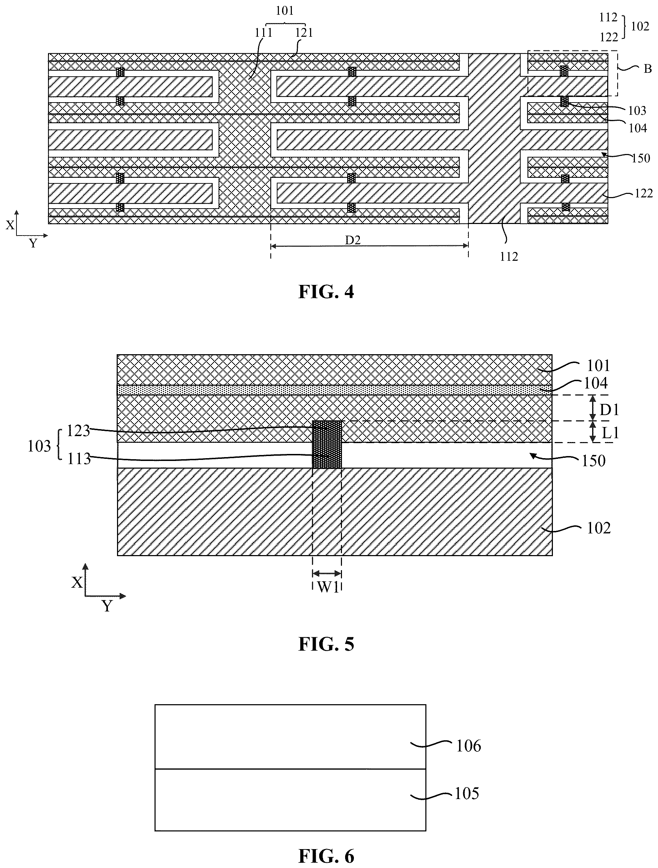

FIG. 4 is another partial top view of a back contact solar cell provided in some embodiments of the present disclosure. FIG. 5 is a partial enlarged schematic diagram of B in FIG. 2.

Referring to FIG. 1, FIG. 4, and FIG. 5, in some embodiments, each respective doped conductive contact 103 of at least some of the doped conductive contacts 103 includes a connecting part 113 and a contact part 123. The connecting part 113 is disposed on a corresponding separating region 150 of the separating regions 150 and is configured for electrically connecting to the second doped conductive layer 102. The contact part 123 is disposed on a corresponding first region 130 of the first regions 130 and is configured for electrically connecting to the first doped conductive layer 101. Since the contact part 123 is disposed on the corresponding first region 130 of the first regions 130, a contact area between the doped conductive contacts 103 and the first doped conductive layer 101 on the corresponding first region 130 is increased by means of the contact part 123. In this way, the doped conductive contacts 103 can better shunt current when the back contact solar cell is locally shaded or experiences local abnormal heating, thereby enhancing an ability of the doped conductive contacts 103 to improve the hot spot effect.

In some embodiments, a length of the contact part 123 along the first direction X is a length L1, and a distance between the contact part 123 and a corresponding first grid line 104 of the first grid lines 104 adjacent to the contact part 123 along the first direction X is a first spacing D1. A ratio of the first spacing D1 to the length L1 ranges from 1 to 10, for example, from 1 to 3, from 3 to 6, or from 6 to 10, such as 1, 2, 3, 4.5, 5, 6, 7, 8, or 10. When the ratio of the first spacing D1 to the length L1 is within the above range, the first spacing D1 is larger, i.e., a spacing between one respective first grid line 104 of the grid lines 104 spaces from a doped conductive contact 103 of the doped conductive contacts 103 adjacent to the respective first grid line 104 along the first direction X is larger. This can avoid the problem of the back contact solar cell having a large reverse saturation current affecting a performance of the back contact solar cell, and the large reverse saturation current is caused by an excessively small spacing between one respective first grid line 104 of the grid lines 104 spaces from a doped conductive contact 103 of the doped conductive contacts 103 adjacent to the respective first grid line 104 along the first direction X.

In some embodiments, the length L1 ranges from 20µm to 100µm, for example, from 20µm to 50µm, from 50µm to 80µm, or from 80µm to 100µm, such as 20µm, 30µm, 40µm, 50µm, 60µm, 70µm, 80µm, 90µm, or 100µm. The length L1 affects the contact area between the doped conductive contacts 103 and the first doped conductive layer 101. The length L1 being within the above range, can avoid the problem of poor current shunting of the doped conductive contacts 103 when the back contact solar cell is locally blocked or experiences local abnormal heating, and the poor current shunting is caused by an excessively small length L1, which results in a small contact area between the doped conductive contacts 103 and the first doped conductive layer 101. The length L1 being within the above range can also avoid a situation where an effective light-emitting area of the first doped conductive layer 101 in the back contact solar cell being excessively small affects a performance of the back contact solar cell, and the excessively small effective light-emitting area is caused by an excessively large length L1, which results in an excessively large contact area between the doped conductive contacts 103 and the first doped conductive layer 101.

In some embodiments, the first spacing D1 ranges from 20µm to 150µm, for example, from 20µm to 60µm, from 60µm to 100µm, or from 100µm to 150µm, such as 20µm, 30µm, 40µm, 60µm, 80µm, 100µm, 120µm, 125µm, or 150µm. The first spacing D1 being within the above range can avoid the problem of the back contact solar cell having a large reverse saturation current affecting a performance of the back contact solar cell, and the large reverse saturation current is caused by an excessively small spacing between one respective first grid line 104 of the grid lines 104 spaces from a doped conductive contact 103 of the doped conductive contacts 103 adjacent to the respective first grid line 104 along the first direction X. The first spacing D1 is a distance between the contact part 123 and a corresponding first grid line 104 of the first grid lines 104 adjacent to the contact part 123 along the first direction X. The first spacing D1 being within the above range can also avoid the problem of the back contact solar cell having too few first grid lines 104 per unit area due to the first spacing D1 being too large, thereby affecting a current collection efficiency of the back contact solar cell.

Referring to FIG. 2, FIG. 4 and FIG. 5, in some embodiments, the first doped conductive layer 101 includes first doped conductive parts 111 each extending along the first direction X and second doped conductive parts 121 each extending along the second direction Y. The second doped conductive layer 102 includes third doped conductive parts 112 extending along the first direction X and fourth doped conductive parts 122 extending along the second direction Y. In the second direction Y, one respective first doped conductive part 111 of the first doped conductive parts 111 spaces from a second doped conductive part 121 of the second doped conductive parts 121 adjacent to the respective first doped conductive part 111 by a second spacing D2, and one respective doped conductive contact 103 of the doped conductive contacts 103 has a width W1 along the second direction Y.

The first doped conductive parts 111 are configured for being in electrical contact with the first grid lines 104. The second doped conductive parts 121 are configured for being in electrical contact with the second grid lines.

A ratio of the width W1 to the second spacing D2 is in a range from 0.01 to 0.05, such as 0.01, 0.02, 0.03, 0.04, or 0.05. The ratio of the width W1 to the second spacing D2 being within the above range can avoid the problem of poor current shunting of the doped conductive contacts 103 when the back contact solar cell is locally shaded or experiences local abnormal heating, and the poor current shunting is caused by an excessively small width W1, which results in a small contact area between the doped conductive contact 103 and the first doped conductive layer 101. The ratio of the width W1 to the second spacing D2 being within the above range can also avoid a situation where an effective light-emitting area of the first doped conductive layer 101 in the back contact solar cell being excessively small affects a performance of the back contact solar cell, and the excessively small effective light-emitting area is caused by an excessively large width W1, which results in an excessively large contact area between the doped conductive contact 103 and the first doped conductive layer 101.

In some embodiments, the width W1 ranges from 40µm to 350µm, for example, 40µm to 100µm, 100µm to 200µm, 200µm to 300µm, or 300µm to 350µm, such as 40µm, 70µm, 100µm, 150µm, 200µm, 250µm, 300µm, 325µm, or 350µm. The width W1 being within the above range can avoid the problem of poor current shunting of the doped conductive contacts 103 when the back contact solar cell is locally shaded or experiences local abnormal heating, and the poor current shunting is caused by an excessively small width W1, which results in a small contact area between the doped conductive contacts 103 and the first doped conductive layer 101 and a small contact area between the doped conductive contacts 103 and the second doped conductive layer 102. The width W1 being within the above range can also avoid a situation where normal power generation efficiencies of the first doped conductive layer 101 and the second doped conductive layer 102 in the back contact solar cell affects a performance of the back contact solar cell, and the normal power generation efficiencies are caused by an excessively large width W1, which results in an excessively large contact area between the doped conductive contact 103 and the first doped conductive layer 101 and an excessively large contact area between the doped conductive contact 103 and the second doped conductive layer 102.

The second spacing D2 ranges from 5mm to 15mm, for example, from 5mm to 10mm or from 10mm to 15mm, such as 5mm, 7.5mm, 8mm, 10mm, 12.5mm, or 15mm. When the second spacing D2 is within the above range, the second spacing D2 is positively correlated with a length of a respective first doped conductive part 111 of the first doped conductive parts 111 along the second direction Y. The first doped conductive parts 111 are portions of the first doped conductive layer 101 that is contact with the first grid lines 104. When the second spacing D2 is within the above range, the contact area between the first grid lines 104 and the first doped conductive layer 101 may be large, thereby facilitating current collection by the first grid lines 104. The second spacing D2 is positively correlated with a length of a respective second doped conductive part 121 of the second doped conductive parts 121 along the second direction Y. The second doped conductive parts 121 are portions of the second doped conductive layer 102 that is contact with the second grid lines. When the second spacing D2 is within the above range, the contact area between the second grid lines and the second doped conductive layer 102 may be large, thereby facilitating current collection by the second grid lines.

In some embodiments, the doped conductive contacts 103 are disposed at equal intervals along the first direction X and disposed at equal intervals along the second direction Y. That is, the doped conductive contacts 103 are evenly distributed on the second side 120. The back contact solar cell is locally blocked or abnormal resulting in local heating, so that the current that may have been concentrated can be evenly dispersed to other normal regions through the doped conductive contacts 103 evenly distributed, thereby avoiding excessive local current density and the resulting excessive heat generation, thereby effectively reducing the risk of hot spots.

In some embodiments, a respective distance between every two adjacent doped conductive contacts 103 of the doped conductive contacts 103 along the first direction X ranges from 4.2mm to 17mm, for example, from 4.2mm to 8mm, from 8mm to 12mm, or from 12mm to 17mm, such as 4.2mm, 5mm, 6.1mm, 9mm, 10mm, 10.6mm, 13mm, 14.5mm, or 17mm. Since the respective distance between every two adjacent doped conductive contacts 103 of the doped conductive contacts 103 along the first direction X is within the above range, when the back contact solar cell is locally blocked or abnormally heated, the doped conductive contacts 103 can promptly shunt the shaded or abnormally heated region, thereby improving a hot spot effect of the back contact solar cell.

A respective distance between every two adjacent doped conductive contacts 103 of the doped conductive contacts 103 along the second direction Y ranges from 5mm to 20mm, for example, from 5mm to 10mm, from 10mm to 15mm, or from 15mm to 20mm, such as 5mm, 7.5mm, 9mm, 10 mm, 11mm, 12.5mm, 13mm, 15mm, 17.5mm, or 20mm. Since the respective distance between every two adjacent doped conductive contacts 103 of the doped conductive contacts 103 along the second direction Y is within the above range, when the back contact solar cell is locally shaded or abnormally heated, the doped conductive contacts 103 can promptly shunt the shaded or abnormally heated region, thereby improving a hot spot effect of the back contact solar cell.

In some embodiments, the doped conductive contacts 103 and the second doped conductive layer 102 are formed integrally. In this way, the doped conductive contacts 103 may be formed simultaneously with the second doped conductive layer 102, thereby improving a preparation efficiency of the back contact solar cell.

In some embodiments, a total area of the contact parts 123 projected on the second side 120 is defined as a first area, and a area of the first doped conductive layer 101 projected on the second side 120 is defined as a second area.

The first area affects a shunting effect of the doped conductive contacts 103 when the back contact solar cell is locally blocked or experiences local abnormal heating. In response to the first area being large, the doped conductive contacts 103 has a large shunting path when the back contact solar cell is locally blocked or experiences local abnormal heating, and the shunting effect of the doped conductive contacts 103 is better. In response to the first area being small, the doped conductive contacts 103 has a small shunting path when the back contact solar cell is locally shaded or experiences local abnormal heating, and the shunting effect of the doped conductive contacts 103 is poor.

A ratio of the first area to the second area ranges from 0.05‰ to 0.2‰, for example, from 0.05‰ to 0.1‰, from 0.1‰ to 0.15‰, or from 0.15‰ to 0.2‰, such as 0.05‰, 0.06%0, 0.08%0, 0.1‰, 0.12‰, 0.14‰, 0.16‰, 0.18‰, or 0.2‰. The ratio of the first area to the second area being within the above range can avoid a problem of poor current shunting of the doped conductive contacts 103 when the back contact solar cell is locally blocked or experiences local abnormal heating, and the poor current shunting is caused by an excessively small first area; as well as a situation where an effective light-emitting area of the first doped conductive layer 101 in the back contact solar cell being excessively small affects a performance of the back contact solar cell, and the excessively small effective light-emitting area is caused by an excessively large first area.

The first area ranges from 0.176mm² to 7.7mm², for example, 0.176mm² to 2mm², 2mm² to 4mm², or 4mm² to 7.7mm², such as 0.176mm², 0.18mm², 0.2mm², 0.5mm², 0.8mm², 1mm², 1.3mm², 1.5mm², 1.8mm², 2mm², 2.3mm², 2.5mm², 2.8mm², 3mm², 3.3mm², 3.5mm², 3.8mm², 4mm², 4.5mm², 5mm², 5.5mm², 6mm², 6.5mm², 7mm², 7.3mm² or 7.6mm². The first area being within the above range can avoid a problem of poor current shunting of the doped conductive contacts 103 when the back contact solar cell is locally blocked or experiences local abnormal heating, and the poor current shunting is caused by an excessively small first area; as well as a situation where an effective light-emitting area of the first doped conductive layer 101 in the back contact solar cell being excessively small affects a performance of the back contact solar cell, and the excessively small effective light-emitting area is caused by an excessively large first area.

The second area ranges from 3520mm² to 38500mm², for example, 3520mm² to 10000mm², 10000mm² to 20000mm², 20000mm² to 30000mm², or 30000mm² to 38500mm², such as 3520mm², 4000mm², 6760mm², 10000mm², 15000mm², 20000mm², 25000mm², 30000mm², 34250mm², 38000mm², or 38500mm². When the second region is within the above range, a contact area between the first doped conductive layer 101 and the substrate 100 is large, so that the first doped conductive layer 101 can effectively collect current, thereby improving the power generation performance of the back contact solar cell.

Table 1 is a summary table of reverse saturation currents of the back contact solar cells of Comparative examples 1 to 4 and reverse saturation currents of the back contact solar cells of Examples 1 to 5. Table 2 is a summary table of differences of performance parameters of the back contact solar cells of Comparative examples 1 to 4 relative to performance parameters of the back contact solar cells of Example 5, and differences of performance parameters of the back contact solar cells of Examples 1 to 4 relative to performance parameters of the back contact solar cells of Example 5. The performance parameters of the back contact solar cell of Example 5 are reference values, and one respective performance parameter of the performance parameters of the back contact solar cells of Comparative examples 1 to 4 and Examples 1 to 4 in the tables is a difference obtained by subtracting one respective performance parameter of the performance parameters of Example 5 from an actual measured parameter. One respective first grid line 104 of the first grid lines 104 spaces from a doped conductive contact 103 of the doped conductive contacts 103 adjacent to the respective first grid line 104 by a first spacing D1. The back contact solar cells of Comparative examples 1 to 4 and Examples 1 to 5 have the same parameters except the first spacing D1. The back contact solar cells of Comparative examples 1 to 4 and Examples 1 to 5 have a length L1 with 100µm, a width W1 with 150µm, and a second spacing D2 with 9mm. A respective distance between every two adjacent doped conductive contacts 103 of the doped conductive contacts 103 along the first direction X is 9.7mm, a respective distance between every two adjacent doped conductive contacts 103 of the doped conductive contacts 103 along the second direction Y is 18mm. A first area is 1.98mm², and a second area is 15620mm².

**Table 1**

| | Comparative example 1 | Comparative example 2 | Comparative example 3 | Comparative example 4 | Example 1 | Example 2 | Example 3 | Example 4 | Example 5 |
|---|---|---|---|---|---|---|---|---|---|
| First spacing | 2µm | 5µm | 10µm | 15µm | 20µm | 25µm | 50µm | 100µm | 150µm |
| Reverse saturation current | 10.505A | 10.131A | 8.496A | 8.484A | 7.699A | 6.694A | 5.958A | 5.758A | 5.758A |

**Table 2**

| | Comparative example 1 | Comparative example 2 | Comparative example 3 | Comparative example 4 | Example 1 | Example 2 | Example 3 | Example 4 | Example 5 |
|---|---|---|---|---|---|---|---|---|---|
| First spacing | 2µm | 5µm | 10µm | 15µm | 20µm | 25µm | 50µm | 100µm | 150µm |
| Short-circuit current difference | -15mA | -12mA | -10mA | -9mA | -9mA | -4mA | -2mA | 0 | - |
| Open-circuit voltage difference | -1.1mV | -1.5mV | -0.9mV | -2mV | 0 | -0.2mV | 0 | 0 | - |
| Conversion efficiency difference | -0.154% | -0.12% | -0.07% | -0.04% | -0.012% | -0.002% | 0 | 0 | - |

It can be seen from Table 1 and Table 2 that when the first spacing is 150µm, the back contact solar cell has the smallest reverse saturation current, and a largest short-circuit current, a largest open-circuit voltage and a largest conversion efficiency. The first spacing is positively correlated with the reverse saturation current of the back contact solar cell. When the first spacing is greater than or equal to 20µm, the reverse saturation current of the back contact solar cell is small, with a small short-circuit current difference, a small open-circuit voltage difference, and a small conversion efficiency difference. Therefore, when the respective first grid line of the first grid lines spaces from the doped conductive contact of the doped conductive contacts adjacent to the respective first grid line by the first spacing greater than or equal to 20µm, the reverse saturation current of the back contact solar cell may be reduced, thereby improving the performance of the back contact solar cell. When the respective first grid line of the first grid lines spaces from the doped conductive contact of the doped conductive contacts adjacent to the respective first grid line by the first spacing greater than or equal to 20µm, the back contact solar cell can also obtain a large open-circuit current, open-circuit voltage and conversion efficiency, which is also beneficial to improving the performance of the back contact solar cell.

Some embodiments of the present disclosure also provide a tandem solar cell, including the back contact solar cell provided in any one of the aforementioned embodiments. The tandem solar cell provided in the embodiments of the present disclosure will be described in detail below with reference to the accompanying drawings. It should be noted that parts that are identical or corresponding to the aforementioned embodiments will not be repeated here.

FIG. 6 is a schematic structural diagram of a tandem solar cell provided in some embodiments of the present disclosure.

Referring to FIG. 1 and FIG. 6, the tandem solar cell includes a bottom cell 105 and a top cell 106. The bottom cell 105 is the back contact solar cell provided in the aforementioned embodiments. The top cell 106 is disposed on the bottom cell 105. The top cell 106 may be disposed on a first side 110 of the bottom cell 105.

In some embodiments, the top cell 106 may include: a first transport layer, a perovskite substrate, a second transport layer, a transparent conductive layer, and an anti-reflection layer that are stacked. The first transport layer is disposed between the bottom cell 105 and the perovskite substrate.

In some embodiments, the first transport layer may be one of an electron transport layer and a hole transport layer, and the second transport layer may be the other of the electron transport layer and the hole transport layer.

Some embodiments of the present disclosure also provide a photovoltaic module, including the back contact solar cell provided in any one of the embodiments, or the tandem solar cell provided in the above embodiments. It should be noted that the same or corresponding parts as those in the above embodiments may refer to the above embodiments and will not be repeated below.

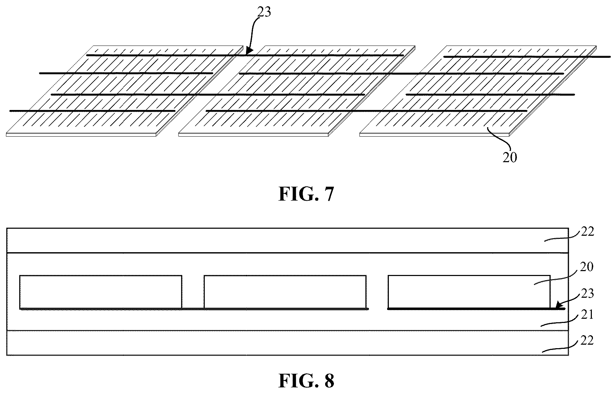

FIG. 7 is a schematic diagram of a partial three-dimensional structure of a cell string in a photovoltaic module provided in some embodiments of the present disclosure. FIG. 8 is a schematic diagram of a cross-sectional structure of a photovoltaic module provided in some embodiments of the present disclosure.

Referring to FIG. 7 and FIG. 8, the photovoltaic module includes at least one cell string formed by connecting a plurality of back contact solar cells 20, or by connecting a plurality of tandem solar cells. Each back contact solar cell 20 of the plurality of back contact solar cells 20 and each tandem solar cell of the plurality of tandem solar cells are described in the above embodiments. The photovoltaic module also includes at least one encapsulating film 21 and at least one cover plate 22. The at least one encapsulating film 21 is configured for covering at least one surface of the at least one cell string, and the at least one cover plate 22 is configured for covering at least one surface of the at least one encapsulating film 21 away from the at least one cell string.

In some embodiments, the at least one cell string further includes solder strips configured for electrically connecting adjacent back contact solar cells 20 of the plurality of back contact solar cells 20, or configured for electrically connecting adjacent tandem solar cells of the plurality of tandem solar cells.

In some embodiments, the encapsulating film 21 includes a first encapsulating layer and a second encapsulating layer. The first encapsulating layer covers one of front and back sides of the back contact solar cell, and the second encapsulating layer covers the other of the front and back sides of the back contact solar cell. Specifically, at least one of the first encapsulating layer and the second encapsulating layer may be an organic encapsulating film such as polyvinyl butyral (PVB) film, ethylenevinyl acetate copolymer (EVA) film, polyethylene octene co-elastomer (POE) film, or polyethylene terephthalate (PET) film. In some embodiments, at least one of the first encapsulating layer and the second encapsulating layer may be such as an EP film, an EPE film, or a PVP film. The EP film is a coextruded film formed by stacking EVA films and POE films, The EPE film is a coextruded film formed by sequentially stacking EVA film, POE film, and EVA film. The PVP film is a coextruded film formed by stacking POE film, EVA film, and POE film. The coextruded film may be prepared by sequentially extruding one or more raw materials onto another already manufactured film during a film processing process, or by bonding different types of already manufactured films together.

In some embodiments, the first encapsulating layer and the second encapsulating layer have boundary lines before lamination. After the lamination process, the photovoltaic module is formed and the first encapsulating layer and the second encapsulating layer no long have boundary lines. That is, the first encapsulating layer and the second encapsulating layer have formed an integral encapsulating film 21.

In some embodiments, the at least one cover plate 22 such as glass cover plate, plastic cover plate, or the like, may have a light-transmitting function. In some embodiments, at least one surface of the at least one cover plate facing the at least one encapsulating film may be a concave-convex surface or a textured surface with multiple protrusion structures, thereby increasing a utilization rate of incident light. The at least one cover plate 22 includes a first cover plate opposite to the first encapsulating layer, and a second cover plate opposite to the second encapsulating layer.

It can be understood by those skilled in the art that the above-mentioned embodiments are only specific implementations of the present disclosure, and various changes may be made in form and in detail in practical applications without departing from the scope of the embodiments of the present disclosure. Various changes and modifications may be made by those skilled in the art without departing from the scope of the embodiments of the present disclosure. Therefore, the protection scope of the embodiments of the present disclosure shall be defined by the appended claims.

## Claims

1. A back contact solar cell, **characterized by** comprising:
a substrate (101) having a first side (110) and an opposing second side (120), wherein the second side (120) includes alternating first regions (130) and second regions (140), and further includes separating regions (150), and each separating region (150) of the separating regions (150) is disposed between a respective first region (130) of the first regions (130) and a respective second region (140) of the second regions (140) adjacent to the respective first region (130);
a first doped conductive layer (101) and a second doped conductive layer (102), wherein the first doped conductive layer (101) is disposed on the first regions (130), the second doped conductive layer (102) is disposed on the second regions (140), and the first doped conductive layer (101) is doped with a dopant element of a conductivity type opposite to that of a dopant element in the second doped conductive layer (102);
doped conductive contacts (103), wherein each doped conductive contact (103) of the doped conductive contacts (103) is at least partially disposed on a respective separating region (150) of the separating regions (150) and is configured for electrically connecting the first doped conductive layer (101) to the second doped conductive layer (102), and the doped conductive contacts (103) are doped with a dopant element of a conductivity type same as that of the dopant element in the second doped conductive layer (102); and
grid lines (104), wherein each grid line (104) of the grid lines (104) is disposed on a respective first region (130) of the first regions (130) and is in electrical contact with the first doped conductive layer (101);
wherein in a first direction (X) perpendicular to an extension direction of the grid lines (104), one respective grid line (104) of the grid lines (104) spaces from a doped conductive contact (103) of the doped conductive contacts (103) adjacent to the respective grid line (104) by a first spacing (D1) greater than or equal to 20µm.

2. The back contact solar cell according to claim 1, wherein each respective doped conductive contact (103) of at least some of the doped conductive contacts (103) includes:
a connecting part (113) disposed on a corresponding separating region (150) of the separating regions (150) and configured for electrically connecting to the second doped conductive layer (102); and
a contact part (123) disposed on a corresponding first region (130) of the first regions (130) and configured for electrically connecting to the first doped conductive layer (101).

3. The back contact solar cell according to claim 2, wherein a ratio of a distance between the contact part and a corresponding grid line (104) of the grid lines (104) adjacent to the contact part along the first direction to a length (L1) of the contact part along the first direction ranges from 1 to 10.

4. The back contact solar cell according to claim 3, wherein the length (L1) of the contact part ranges from 20µm to 100µm, and the distance between the contact part and the corresponding grid line (104) along the first direction ranges from 20µm to 150µm.

5. The back contact solar cell according to claim 2, wherein the first doped conductive layer (101) includes first doped conductive parts (111) each extending along the first direction (X) and second doped conductive parts (121) each extending along a second direction (Y) parallel to the extension direction of the grid lines (104), and the second doped conductive layer (102) includes third doped conductive parts (112) each extending along the first direction (X) and fourth doped conductive parts (122) each extending along the second direction (Y); and
in the second direction (Y), one respective first doped conductive part (111) of the first doped conductive parts (111) spaces from a second doped conductive part (121) of the second doped conductive parts (121) adjacent to the respective first doped conductive part (111) by a second spacing (D2), and a ratio of a width (W1) of one respective doped conductive contact (103) of the doped conductive contacts (103) along the second direction (Y) to the second spacing (D2) ranges from 0.01 to 0.05.

6. The back contact solar cell according to claim 5, wherein the width (W1) ranges from 40µm to 350µm, and the second spacing (D2) ranges from 5mm to 15mm.

7. The back contact solar cell (20) according to any one of claims 1 to 6, wherein the doped conductive contacts (103) are disposed at equal intervals along the first direction (X) and disposed at equal intervals along a second direction (Y) parallel to the extension direction of the grid lines (104).

8. The back contact solar cell according to claim 7, wherein along the first direction (X), a respective distance between every two adjacent doped conductive contacts (103) of the doped conductive contacts (103) ranges from 4.2mm to 17mm, and along the second direction (Y), a respective distance between every two adjacent doped conductive contacts (103) of the doped conductive contacts (103) ranges from 5mm to 20mm.

9. The back contact solar cell according to claim 1, wherein the doped conductive contacts (103) and the second doped conductive layer (102) are formed integrally.

10. A tandem solar cell, including:
a bottom cell (105), wherein the bottom cell is the back contact solar cell according to any one of claims 1 to 9; and
a top cell (106) disposed on the bottom cell (105).

11. The tandem solar cell according to claim 10, wherein each respective doped conductive contact (103) of at least some of the doped conductive contacts (103) includes:
a connecting part (113) disposed on a corresponding separating region (150) of the separating regions (150) and configured for electrically connecting to the second doped conductive layer (102); and
a contact part (123) disposed on a corresponding first region (130) of the first regions (130) and configured for electrically connecting to the first doped conductive layer (101).

12. The tandem solar cell according to claim 11, wherein a ratio of a distance between the contact part and a corresponding grid line (104) of the grid lines (104) adjacent to the contact part along the first direction to a length (L1) of the contact part along the first direction ranges from 1 to 10.

13. The tandem solar cell according to claim 12, wherein the length (L1) of the contact part ranges from 20µm to 100µm, and the distance between the contact part and the corresponding grid line (104) along the first direction ranges from 20µm to 150pum.

14. The tandem solar cell according to claim 11, wherein the first doped conductive layer (101) includes first doped conductive parts (111) each extending along the first direction (X) and second doped conductive parts (121) each extending along a second direction (Y) parallel to the extension direction of the grid lines (104), and the second doped conductive layer (102) includes third doped conductive parts (112) each extending along the first direction (X) and fourth doped conductive parts (122) each extending along the second direction (Y); and
in the second direction (Y), one respective first doped conductive part (111) of the first doped conductive parts (111) spaces from a second doped conductive part (121) of the second doped conductive parts (121) adjacent to the respective first doped conductive part (111) by a second spacing (D2), and a ratio of a width (W1) of one respective doped conductive contact (103) of the doped conductive contacts (103) along the second direction (Y) to the second spacing (D2) ranges from 0.01 to 0.05.

15. A photovoltaic module, including:
at least one cell string formed by connecting a plurality of back contact solar cell (20) or, formed by connecting a plurality of tandem solar cells, wherein each back contact solar cell (20) of the plurality of back contact solar cells (20) is the back contact solar cell (20) according to any one of claims 1 to 9, and each tandem solar cell of the plurality of tandem solar cells is the tandem solar cell according to any one of claims 10 to 14;
at least one encapsulating film (21) configured for covering at least one surface of the at least one cell string; and
at least one cover plate (22) configured for covering at least one surface of the at least one encapsulating film away from the at least one cell string.
